# EUROPEAN PATENT APPLICATION

(11) **EP 4 847 931 A1**
(43) Date of publication of application: **02.12.2026**
(21) Application number: 25861150.8
(22) Date of filing: 10.07.2025
(51) Int. Cl.: G01R 31/367, G01R 31/36, G01R 31/396, G01R 31/392, B60L 58/16, H02J 7/00

(54) **ELECTRONIC DEVICE, RECORDING MEDIUM, AND BATTERY DEGRADATION FACTOR ANALYSIS METHOD THEREFOR**

(30) Priority: 30.08.2024 KR 20240117680; 24.10.2024 KR 20240146419
(71) Applicant: LG ENERGY SOLUTION, LTD., Seoul 07335 (KR)
(72) Inventor: KIM, Kangsan, Yuseong-gu, Daejeon 34122 (KR); SEO, Bo Kyung, Yuseong-gu, Daejeon 34122 (KR); CHO, Jae Young, Yuseong-gu, Daejeon 34122 (KR); KIM, Jangkyum, Yuseong-gu, Daejeon 34122 (KR); SEO, Hyeonseok, Yuseong-gu, Daejeon 34122 (KR)
(74) Representative: Plasseraud IP
(86) International application number: PCT/KR2025/010078
(87) International publication number: WO 2026/049284

(57) **Abstract**

An electronic device for analyzing a battery degradation factor is provided. The electronic device can: acquire a plurality of pieces of battery charging data for a plurality of vehicles; identify, on the basis of the plurality of pieces of battery charging data, a plurality of factors related to battery charging; generate a plurality of factor combinations on the basis of the plurality of factors; generate, for respective factor combinations, on the basis of one or more pieces of battery charging data corresponding thereto, a plurality of factor combination features indicating a charging pattern related to the factor combination; perform, on the basis of a clustering algorithm, clustering on the plurality of factor combination features indicating a charging pattern related to the same factor combination; on the basis of a deviation in data distribution between a plurality of clusters generated to correspond to respective factor combinations; extract, from among the plurality of factor combinations, one or more factor combinations corresponding to factor combinations related to battery degradation; identify, on the basis of an artificial intelligence-based model, information related to the effect of each of the one or more factor combinations on battery degradation; and provide, on the basis of the information related to the effect on battery degradation, information related to an optimal factor combination for preventing battery degradation.

## Description

### Technical Field

The present disclosure relates to an electronic apparatus, a recording medium, and a method for analyzing a factor of battery degradation thereof, and more specifically, to a technology for selecting factors having effects on battery degradation based on various and complicated charging patters of an electric vehicle user and analyzing a relative effect among the selected factors and an optimal battery degradation preventive measure.

This application claims the benefit of Korean Patent Application No. 2024-0117680, filed on August 30, 2024, and Korean Patent Application No. 2024-0146419, filed on October 24, 2024, in the Korean Intellectual Property Office, the disclosures of which are incorporated herein by reference in their entirety.

### Background Art

Based on various data with respect to a charging pattern of an electric vehicle user, in order to select factors having an effect on battery degradation, an artificial intelligence (AI) technology may be utilized. Nevertheless, because, in a case of prior art which analyzes a factor with respect to a specific circumstance or environment based on an AI technology and the like, a factor analysis is performed in a manner of analyzing an effect on an environment of a specific factor in a circumstance in which remaining factors except the specific factor are fixed, an analysis with respect to an associative relation between various factors itself, an analysis on an effect depending on such a multifactorial relation and the like are excluded. Therefore, a limitation may arise in that an analysis result which is more or less different from an actual environment may be deduced.

Meanwhile, as an alternative measure in consideration thereof, a correlation analysis method of prior art may be performed. Nevertheless, even when a correlation analysis is utilized, there is a problem that merely a linearity or monotonicity increasing relation between a specific factor and another factor may be analyzed, and that a complicated mathematical correlation between factors is difficult to be precisely analyzed, and also that an analysis of an environmental change according to a passage of time such as a degradation triggering analysis in a battery operation environment is almost impossible. Accordingly, a necessity for a measure capable of more minutely analyzing factors having an effect on battery degradation by considering multiple factors having an associative relation with each other in a complex manner based on complicated behavior related to charging of an electric vehicle user is arising.

### Detailed Description of the Invention

### Technical Goals

To solve these problems, according to an example embodiment of the present disclosure, provided are an electronic apparatus and a method for analyzing a factor of battery degradation thereof.

Technical goals to be achieved by the example embodiments are not limited thereto, and other technical goals may be inferred from example embodiments below.

### Technical solutions

According to an example embodiment, an electronic apparatus includes a transceiver, a processor, and one or more memories storing one or more instructions. Here, when the one or more instructions are executed, the processor is configured to obtain a plurality of battery charging data with respect to a plurality of vehicles, identify, based on the plurality of battery charging data, a plurality of factors related to charging of a battery, generate, based on the plurality of factors, a plurality of factor combinations, generate, with respect to each of the plurality of factor combinations, a plurality of factor combination features indicating a charging pattern related to a factor combination based on one or more corresponding battery charging data, perform, based on a clustering algorithm, clustering targeted at a plurality of factor combination features indicating a charging pattern related to an identical factor combination, extract, based on a deviation of data distribution among a plurality of clusters generated to correspond to each of the plurality of factor combinations, one or more factor combinations corresponding to a factor combination related to battery degradation among a plurality of factor combinations, identify, based on an artificial intelligence-based model, information related to an effect on battery degradation caused by each of the one or more factor combinations, and provide, based on the information related to the effect on battery degradation, information related to an optimal factor combination for preventing battery degradation.

According to an example embodiment, the plurality of battery charging data are data collected with respect to each of a plurality of batteries included in the plurality of vehicles during a predetermined period, and include at least one of information related to a state of charge (SoC) of a battery according to time, information related to a charging current rate (C-rate) of a battery according to time, information related to a charging temperature of a battery according to time, and information related to a charging cycle of a battery according to time.

According to an example embodiment, the plurality of factors include at least one of a charging starting SoC, a charging ending SoC, a C-rate, a charging temperature, a charging cycle and a charging time zone.

According to an example embodiment, when the one or more instructions are executed, the processor is configured to identify one or more battery charging data corresponding to a first factor included in a first factor combination among the plurality of factor combinations, and one or more battery charging data corresponding to a second factor included in the first factor combination, and generate, based on the one or more battery charging data corresponding to the first factor and the one or more battery charging data corresponding to the second factor, a plurality of first factor combination features indicating a charging pattern related to the first factor combination.

According to an example embodiment, when the one or more instructions are executed, the processor is configured to perform, based on a clustering algorithm, clustering of a plurality of first factor combination features corresponding to a first factor combination among the plurality of factor combination features as a plurality of first clusters, identify whether a deviation between distributions of a variation of a state of health (SoH) of a battery corresponding to each of the plurality of first clusters satisfies a first condition, and identify, in a case in which the deviation between the distributions of the variation of the SoH corresponding to each of the plurality of first clusters satisfies the first condition, that the first factor combination corresponds to the factor combination related to battery degradation.

According to an example embodiment, the distributions of the variation of the SoH corresponding to each of the plurality of first clusters are distributions formed based on a variation of an SoH corresponding to each of one or more first factor combination features included in each of the plurality of first clusters.

According to an example embodiment, the first condition includes at least one of a condition as to whether data distributions of each of a plurality of clusters overlap each other and a condition with respect to a difference between data average values of each of a plurality of clusters.

According to an example embodiment, the artificial intelligence-based model is a model constructed by modeling a correlation between a learning input data set and a learning output data set with each of a plurality of factor combination features corresponding to each of the one or more factor combinations and an SoH value of a vehicle corresponding to each of the plurality of factor combination features being the learning input data set, and a variation of an SoH of a vehicle corresponding to each of the plurality of factor combination features being the learning output data set.

According to an example embodiment, when the one or more instructions are executed, the processor is configured to extract, with respect to each of the one or more factor combinations, representative factor combination features corresponding to a first type or a second type, generate a plurality of input data sets including a predetermined SoH value and the extracted representative factor combination features, with only one of the representative factor combination features included in each of the plurality of input data sets being generated to correspond to the second type, input the plurality of input data sets into the artificial intelligence-based model, and identify variations of an SoH corresponding to each of the plurality of input data sets outputted from the artificial intelligence-based model as the information related to the effect on battery degradation caused by each of the one or more factor combinations.

According to an example embodiment, when the one or more instructions are executed, the processor is configured to identify an input data set corresponding to a smallest value among the variations of the SoH corresponding to each of the plurality of input data sets, and identify a factor combination corresponding to the second type among representative factor combination features included in the identified input data set as the optimal factor combination.

According to an example embodiment, the artificial intelligence-based model is a model further trained to output an optimal factor combination set in which at least one factor combination is changed to correspond to an input data set based on variations of an SoH corresponding to an input data set.

According to an example embodiment, when the one or more instructions are executed, the processor is configured to extract, with respect to each of the one or more factor combinations, representative factor combination features corresponding to a first type or a second type, generate a plurality of input data sets including a predetermined SoH value and the extracted representative factor combination features, with the plurality thereof corresponding to every number of cases related to extraction of the representative factor combination features of each of the one or more factor combinations, input the plurality of input data sets into the trained model, identify the optimal factor combination set corresponding to each of the plurality of input data sets outputted from the trained model, and provide the optimal factor combination set corresponding to each of the plurality of input data sets as the information related to the optimal factor combination.

According to an example embodiment, a method for analyzing a factor of battery degradation includes obtaining a plurality of battery charging data with respect to a plurality of vehicles, identifying, based on the plurality of battery charging data, a plurality of factors related to charging of a battery, generating, based on the plurality of factors, a plurality of factor combinations, generating, with respect to each of the plurality of factor combinations, a plurality of factor combination features indicating a charging pattern related to a factor combination based on one or more corresponding battery charging data, performing, based on a clustering algorithm, clustering targeted at a plurality of factor combination features indicating a charging pattern related to an identical factor combination, extracting, based on a deviation of data distribution among a plurality of clusters generated to correspond to each of the plurality of factor combinations, one or more factor combinations corresponding to a factor combination related to battery degradation among a plurality of factor combinations, identifying, based on an artificial intelligence-based model, information related to an effect on battery degradation caused by each of the one or more factor combinations, and providing, based on the information related to the effect on battery degradation, information related to an optimal factor combination for preventing battery degradation.

According to an example embodiment, in a non-transitory computer-readable recording medium having a program for executing a method for analyzing a factor of battery degradation on a computer, the method for analyzing the factor of battery degradation includes obtaining a plurality of battery charging data with respect to a plurality of vehicles, identifying, based on the plurality of battery charging data, a plurality of factors related to charging of a battery, generating, based on the plurality of factors, a plurality of factor combinations, generating, with respect to each of the plurality of factor combinations, a plurality of factor combination features indicating a charging pattern related to a factor combination based on one or more corresponding battery charging data, performing, based on a clustering algorithm, clustering targeted at a plurality of factor combination features indicating a charging pattern related to an identical factor combination, extracting, based on a deviation of data distribution among a plurality of clusters generated to correspond to each of the plurality of factor combinations, one or more factor combinations corresponding to a factor combination related to battery degradation among a plurality of factor combinations, identifying, based on an artificial intelligence-based model, information related to an effect on battery degradation caused by each of the one or more factor combinations, and providing, based on the information related to the effect on battery degradation, information related to an optimal factor combination for preventing battery degradation.

### Effects of the Invention

According to the present disclosure, it is possible to distinguish a factor combination capable of minimizing battery degradation by analyzing various combinations of various factors having an effect on battery degradation.

Further, according to the present disclosure, it is possible to provide an optimal solution for preventing battery degradation by analyzing a charging pattern of electric vehicle users in detail.

The effects to be obtained in the present disclosure are not limited to the aforementioned effects, and other effects not mentioned herein will be clearly understood by those skilled in the art from the description of claims.

### Brief Description of Drawings

FIG. 1 illustrates a block diagram of an electronic apparatus according to an example embodiment.
FIG. 2 illustrates a flowchart of a method for analyzing a factor of battery degradation according to an example embodiment.
FIG. 3 illustrates a process of generating a factor combination feature according to an example embodiment.
FIG. 4 illustrates a process of extracting one or more factor combinations based on a clustering algorithm according to an example embodiment.
FIG. 5 illustrates data distribution among a plurality of clusters related to a factor combination 1 according to an example embodiment.
FIG. 6 illustrates data distribution among a plurality of clusters related to a factor combination 2 according to an example embodiment.
FIG. 7 illustrates a process of identifying information related to an effect on battery degradation caused by each of one or more factor combinations based on an artificial intelligence-based model according to an example embodiment.
FIG. 8 illustrates a process of training an artificial intelligence-based model according to an example embodiment.
FIG. 9 illustrates an input data set and an output data set of an artificial intelligence-based model according to an example embodiment.
FIG. 10 illustrates a process of identifying an optimal factor combination set based on an artificial intelligence-based model according to an example embodiment.
FIG. 11 illustrates an input data set and an output data set of a trained artificial intelligence-based model according to an example embodiment.

### Mode for Carrying Out the Invention

Terms used in example embodiments are selected from currently widely used general terms when possible while considering the functions in the present disclosure. However, the terms may vary depending on the intention of a person skilled in the art, precedents, the emergence of new technology, and the like. Further, in particular cases, there are also terms arbitrarily selected by the applicant, and in these cases, the meaning will be described in detail in the corresponding descriptions. Therefore, the terms used in the present disclosure are not to be construed simply as its designation but based on the meaning of the term and the overall context of the present disclosure.

In the entire specification, when an element is referred to as "comprising" or "including" another element, the element should not be understood as excluding other elements as long as there is no special conflicting description, and the element may include at least one other element. Furthermore, terms such as "... unit" and "... module" described in the specification mean a unit that processes at least one function or operation, which may be implemented as hardware, software, or a combination thereof.

Expression "at least one of a, b and c" described throughout the specification may include "a alone," "b alone," "c alone," "a and b," "a and c," "b and c," or "all of a, b and c."

Hereinafter, example embodiments of the present disclosure will be described in detail with reference to the accompanying drawings in order for those of ordinary skill in the art to which the present disclosure pertains to easily implement example embodiments of the present disclosure. However, the present disclosure may be implemented in many different forms and is not limited to the example embodiments described herein.

Hereinafter, example embodiments of the present disclosure related to an electronic apparatus for clustering of data with respect to a charging pattern of a battery will be described in detail with reference to the drawings.

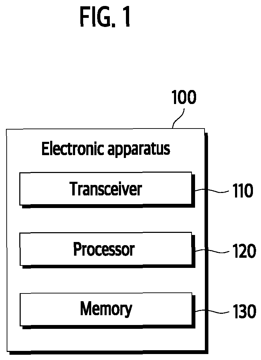

FIG. 1 illustrates a block diagram of an electronic apparatus according to an example embodiment.

Referring to FIG. 1, an electronic apparatus 100 may include a transceiver 110, a processor 120, and a memory 130 according to an example embodiment. In the electronic apparatus 100 illustrated in FIG. 1, only elements which are relevant to the example embodiment are illustrated. Therefore, it will be understood by those skilled in the art to which the example embodiment pertains that other general-purpose elements may be further included in addition to the elements illustrated in FIG. 1.

For example, the electronic apparatus 100 may include a communication device, an input part and an output part including one or more transceivers 110. As a device for performing wired/wireless communication, the communication device may communicate with an external electronic apparatus. The external electronic apparatus may be a terminal or a server. Further, communication technologies used by communication devices may include global system for mobile communication (GSM), code division multi access (CDMA), long term evolution (LTE), 5G, wireless LAN (WLAN), wireless-fidelity (Wi-Fi), Bluetooth, radio frequency identification (RFID), infrared data association (IrDA), ZigBee, near field communication (NFC) and so on. The input part may be, for example, a traditional keypad or keyboard, a mouse, a microphone for receiving voice signals, a camera, or various other input means for detecting or receiving user input. The output part may be, for example, a display that outputs images, a speaker that outputs sounds, a haptic device that generates vibrations, and various other forms of output means.

According to an example embodiment, the electronic apparatus 100 may be a server which obtains and processes data with respect to a plurality of vehicles. Specifically, data with respect to a plurality of vehicles may include a plurality of battery charging data with respect to the plurality of vehicles. A plurality of battery charging data may be obtained from at least one of diagnostic devices (On-Board Diagnostics, OBD) mounted on each vehicle, a battery management system (BMS), and a device (for instance, a database) in which battery charging data are stored in advance via, for example, the transceiver 110 of the electronic apparatus 100. A method for the electronic apparatus 100 obtaining a plurality of battery charging data is not limited to the example above, and it will be apparent to those who are skilled in the art that the electronic apparatus 100 may be obtained from various apparatuses communicable via the transceiver 110. A type of the electronic apparatus 100 is not limited thereto, and various example embodiments of the present disclosure may be applied to various apparatuses which may obtain and process data with respect to a vehicle.

The processor 120 may control an overall operation of the electronic apparatus 100 and process data and signals. The processor 120 may consist of at least one hardware unit. Further, the processor 120 may be operated by one or more software modules generated by executing program code stored in the memory 130. Since the processor 120 may include a memory, the processor 120 may control the overall operation of the electronic apparatus 100 and process data and signals by executing program code stored in the memory.

The processor 120 may be implemented as a computer or similar device using hardware, software, or a combination thereof. In terms of hardware, the processor 120 may be implemented in the form of an electronic circuit that processes electrical signals and performs control functions, and in terms of software, the processor 120 may be implemented in the form of a program that drives the hardware processor 120. Meanwhile, unless otherwise specifically stated in the following description, the operation of the electronic apparatus may be interpreted as being performed under the control of the processor 120. In other words, when modules implemented in a system for clustering data with respect to a charging pattern of a battery are executed, the modules may be interpreted as controlling the processor 120 to perform operations of the electronic apparatus 100 below.

The memory 130 may store various kinds of information. The memory 130 may temporarily or semi-permanently store data. For instance, in the memory 130 of the electronic apparatus 100, data with respect to an operating system (OS) for operating the electronic apparatus 100 and the like may be stored. Examples of the memory 130 may include a hard disk drive (HDD), a solid state drive (SSD), a flash memory, a read-only memory (ROM), a random access memory (RAM) and the like. The memory 130 thereof may be provided as built-in or removable types.

In summary, various example embodiments may be implemented through various means. For example, the various example embodiments may be implemented by hardware, firmware, software, or a combination thereof.

In the case of hardware implementation, methods according to various example embodiments may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors and so on.

In the case of implementation by firmware or software, the methods according to various example embodiments may be implemented in the form of modules, procedures or functions that perform the functions or operations described above. For example, software code may be stored in a memory and executed by a processor. The memory may be located inside or outside the processor, and may exchange data with the processor by various means already known.

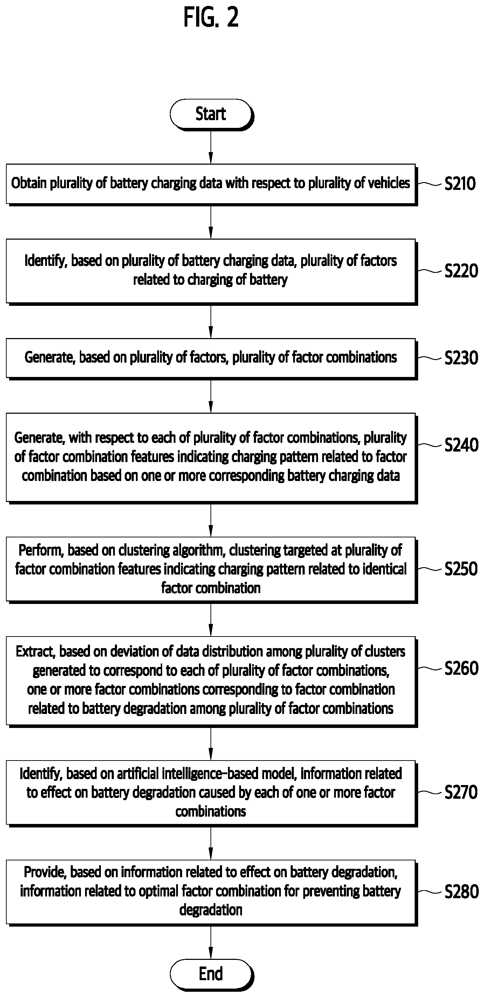

FIG. 2 illustrates a flowchart of a method for analyzing a factor of battery degradation according to an example embodiment.

In operation S210, the electronic apparatus 100 may obtain a plurality of battery charging data with respect to a plurality of vehicles. Here, the plurality of battery charging data may be data collected with respect to each of a plurality of batteries included in the plurality of vehicles during a predetermined period, and include at least one of information related to a state of charge (SoC) of a battery according to time, information related to a charging current rate (C-rate) of a battery according to time, information related to a charging temperature of a battery according to time, and information related to a charging cycle of a battery according to time. The predetermined period may be a period during which charging and discharging of a battery of a vehicle may be repeated by several times, and may be one month, for instance. Therefore, the plurality of battery charging data may include a plurality of time series data including various kinds of information related to charging of a battery such as an SoC change, a C-rate change, a charging temperature change, a charging time cycle change and the like according to time during which charging and discharging of each of the plurality of batteries included in the plurality of vehicles are repeated by several times.

In operation S220, the electronic apparatus 100 may identify, based on the plurality of battery charging data, a plurality of factors related to charging of a battery. Here, the plurality of factors may include at least one of a charging starting SoC, a charging ending SoC, a C-rate, a charging temperature, a charging cycle and a charging time zone. For instance, in a case in which the plurality of battery charging data include time series data indicating an SoC change according to time, the electronic apparatus 100 may identify the charging starting SoC and the charging ending SoC as factors included in the plurality of factors. In another instance, in a case in which the plurality of battery charging data include time series data indicating a charging time cycle change according to time, the electronic apparatus 100 may identify a charging time cycle and a charging time zone as factors included in the plurality of factors. Because the plurality of battery charging data may include various time series data related to charging of a battery, the electronic apparatus 100 may identify one or more various factors corresponding to each of battery charging data according to an example embodiment, without being necessarily limited to the above-described examples of factors.

In operation S230, the electronic apparatus 100 may generate, based on the plurality of factors, a plurality of factor combinations. Generation of factor combinations may be performed in, for instance, a random manner. In other words, the electronic apparatus 100 may generate the plurality of factor combinations which are combined after two factors are randomly selected among the plurality of factors. As a specific example, the electronic apparatus 100 may generate a factor combination 1 consisting of a charging starting SoC and a charging ending SoC, a factor combination 2 consisting of a charging C-rate and a charging temperature, and the like.

In operation S240, the electronic apparatus 100 may generate, with respect to each of the plurality of factor combinations, a plurality of factor combination features indicating a charging pattern related to a factor combination based on one or more corresponding battery charging data. Specifically, the electronic apparatus 100 may identify one or more battery charging data corresponding to a first factor included in a first factor combination among the plurality of factor combinations, and one or more battery charging data corresponding to a second factor included in the first factor combination, and generate, based on the one or more battery charging data corresponding to the first factor and the one or more battery charging data corresponding to the second factor, a plurality of first factor combination features indicating a charging pattern related to the first factor combination.

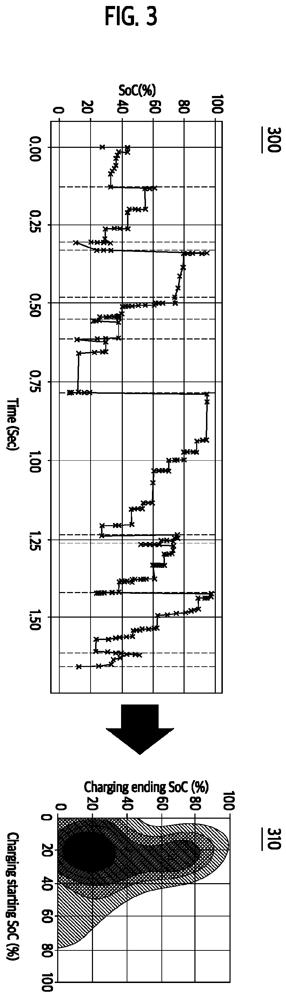

In other words, the electronic apparatus 100 may identify a plurality of battery charging data related to each of one or more vehicles corresponding to a factor combination to generate a feature among a plurality of battery charging data for each factor combination, and generate a plurality of factor combination features indicating a charging pattern related to the corresponding factor combination based thereon, thereby generating a plurality of factor combination features for each factor combination. A more specific example embodiment for generating a plurality of factor combination features corresponding to a specific factor combination will be described in detail with reference to FIG. 3 hereinafter.

Meanwhile, each of the plurality of factor combination features which are generated may be image data indicating a charging pattern related to a factor combination. Here, the charging pattern related to the factor combination may signify, for instance, a characteristic tendency appearing by mutual interaction between various factors included in the factor combination during a battery charging process. As a specific example, a charging pattern related to the factor combination 1 may be a pattern with respect to a frequency of a charging section during which charging starts and ends, and, as another example, a charging pattern related to the factor combination 2 may be a pattern with respect to a frequency of a combination of a C-rate and a charging temperature. Each factor combination feature indicating such a charging pattern may be, for instance, image data of a two-dimensional form, and each of a width and a height of an image may respectively correspond to factors constituting a factor combination.

In operation S250, the electronic apparatus 100 may perform, based on a clustering algorithm, clustering targeted at the plurality of factor combination features indicating a charging pattern related to an identical factor combination. In other words, the electronic apparatus 100 may perform clustering for each of the plurality of factor combination features for each factor combination, and, accordingly, a plurality of clusters may be generated for each factor combination. Here, the clustering algorithm may be an algorithm for dividing performance target data into a cluster having a similar characteristic (for instance, similarity in images, a distance between data and the like), and the electronic apparatus 100 may utilize the clustering algorithm of various types according to example embodiments.

As a more specific example, the electronic apparatus 100 may perform clustering targeted at the plurality of factor combination features for each factor combination based on a hierarchical clustering algorithm which hierarchizes clustering target data among clustering algorithms which may set, as a parameter, (in other words, may hyper-parameterize) the number of clusters. The hierarchical clustering algorithm may provide an advantage of a significantly small calculation performance amount by repeating a process of generating an initial similarity matrix based on a similarity in characteristics between clusters before combining clusters with a high similarity or dividing the same into a sub-cluster based thereon.

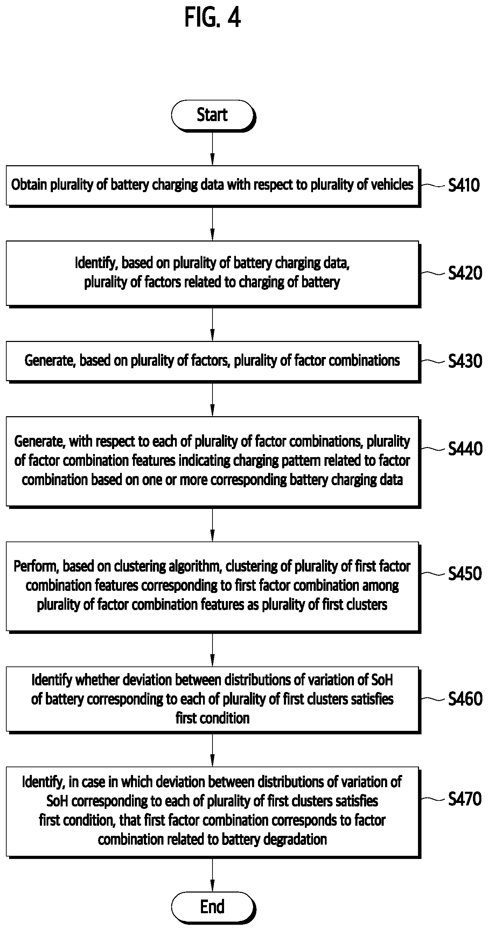

In operation S260, the electronic apparatus 100 may extract, based on a deviation of data distribution among a plurality of clusters generated to correspond to each of the plurality of factor combinations, one or more factor combinations corresponding to a factor combination related to battery degradation among the plurality of factor combinations. In other words, the electronic apparatus 100 may analyze a deviation of data distribution among a plurality of clusters which are generated for each factor combination as a result of clustering performed by being targeted at the plurality of factor combination features for each factor combination, and extract one or more factor combinations which are decided to have an effect on battery degradation based on an analysis result. A more specific example embodiment in which the electronic apparatus 100 analyzes the result of clustering for each factor combination to extract one or more factor combinations will be described in detail hereinafter with reference to FIG. 4.

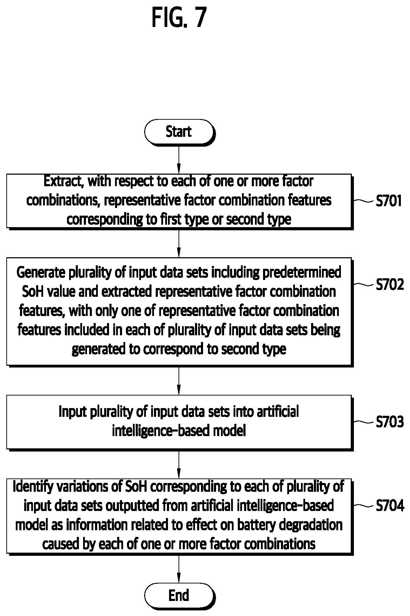

In operation S270, the electronic apparatus 100 may identify, based on an artificial intelligence-based model, information related to an effect on battery degradation caused by each of one or more factor combinations. The information related to the effect on battery degradation caused by each of the one or more factor combinations may be information related to a variation (for the sake of convenience, referred to as "a difference of a state of health (dSoH)" hereinafter) of a state of health (SoH) of a battery according to each of the one or more factor combinations, for instance. Here, the dSoH may be an index indicating how much an SoH, which is a state of health of a battery, has changed during a specific time section, and may be calculated by, for instance, a difference between an SoH of a point in time at which the dSoH is to be measured and a variation of an SoH of a specific point in time prior thereto. Because the dSoH may be interpreted as a performance degradation speed of a battery, the same may be utilized as an index obtained by quantitatively measuring a degree of battery degradation. A more specific example embodiment in which the electronic apparatus 100 identifies the information related to the dSoH according to each of the one or more factor combinations based on the artificial intelligence-based model will be described in detail hereinafter with respect to to FIG. 7 to FIG. 9.

In operation S280, the electronic apparatus 100 may provide, based on the information related to the effect on battery degradation, information related to an optimal factor combination for preventing battery degradation. Here, the optimal factor combination for preventing battery degradation may be, for instance, a factor combination causing a dSoH value to be the smallest.

FIG. 3 illustrates a process of generating a factor combination feature according to an example embodiment.

Referring to FIG. 3, the electronic apparatus 100 may generate a factor combination feature with respect to the factor combination 1 consisting of a charging starting SoC and a charging ending SoC. Among a plurality of battery charging data with respect to a plurality of vehicles, battery charging data related to the factor combination 1 may be in a form of a time series graph 300 having time as an x axis and an SoC as a y axis. Specifically, the time series graph 300 may include SoC information of a specific vehicle battery during a predetermined period, and more specifically, may include information related to a charging section identified whenever the corresponding battery is charged. Accordingly, the time series graph 300 may indicate at what degree of an SoC charging starts and at what degree of an SoC the charging ends whenever the battery is charged. The electronic apparatus 100 may analyze frequency of a plurality of charging sections identified based on the time series graph 300 which is battery charging data to estimate a probability distribution function related to frequency of the charging sections, and, based on the estimated probability distribution function, a factor combination feature 310 with respect to the factor combination 1 may be generated.

Here, a factor combination feature which is generated based on one of battery charging data such as the time series graph 300 may be one factor combination feature, and, according to another example embodiment, may be a plurality of factor combination features generated to correspond to each of divided time sections after the battery charging data are divided into the predetermined time sections. In other words, a factor combination feature which is generated to correspond to one vehicle battery may be singular or plural.

The factor combination feature 310 may be in a two-dimensional image shape with a charging starting SoC being an x axis and a charging ending SoC being a y axis, and a shadow of the factor combination feature 310 may signify frequency of a charging section. In other words, the darker a shadow in the factor combination feature 310 appears, the more frequently a battery may be charged in the section. Accordingly, the factor combination feature 310 may indicate a charging habit or tendency as to mostly at what degree of an SoC charging starts and at what degree of an SoC charging ends in a vehicle, and, as a more specific example, the factor combination feature 310 may indicate that a user of a first vehicle has a charging habit of mostly starting charging at a low SoC and ends charging at a low SoC.

Meanwhile, in an example in which a plurality of factor combination features corresponding to the factor combination 2 are generated, the electronic apparatus 100 may identify one or more battery charging data corresponding to a charging C-rate and one or more battery charging data corresponding to a charging temperature, and may analyze frequency of combination of the charging C-rate and the charging temperature by a joint probability distribution estimation method which is a method of estimating a probability by which two or more probability variables simultaneously have a specific value based thereon. Next, a plurality of features indicating a relation between the charging C-rate and the charging temperature which is analyzed may be generated. Here, the generated features may be in a two-dimensional image form with the charging C-rate and the charging temperature respectively being an x axis and a y axis.

FIG. 4 illustrates a process of extracting one or more factor combinations based on a clustering algorithm according to an example embodiment.

According to an example embodiment, the electronic apparatus 100 may obtain a plurality of battery charging data with respect to a plurality of vehicles (operation S410), identify, based on the plurality of battery charging data, a plurality of factors related to charging of a battery (operation S420), generate, based on the plurality of factors, a plurality of factor combinations (operation S430), and generate, with respect to each of the plurality of factor combinations, a plurality of factor combination features indicating a charging pattern related to a factor combination based on one or more corresponding battery charging data (operation S440).

Next, the electronic apparatus 100 may perform, based on a clustering algorithm, clustering of a plurality of first factor combination features corresponding to a first factor combination among the plurality of factor combination features as a plurality of first clusters (operation S450). The electronic apparatus 100 may identify, as a result of having performed clustering, whether a deviation between distributions of a variation of an SoH (dSoH) corresponding to each of the plurality of first clusters satisfies a first condition (operation S460), and identify, in a case in which the deviation between the distributions of the dSoH corresponding to each of the plurality of first clusters satisfies the first condition, that the first factor combination corresponds to the factor combination related to battery degradation (operation S470).

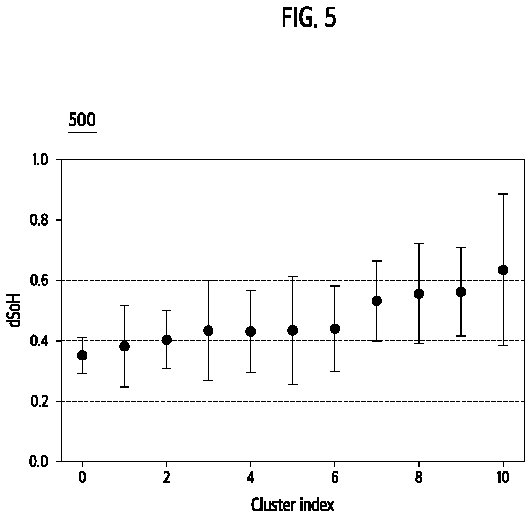

Here, the distributions of the dSoH corresponding to each of the plurality of first clusters may be distributions formed based on a dSoH corresponding to each of one or more first factor combination features included in each of the plurality of first clusters. In other words, the distributions of the dSoH corresponding to each of the plurality of first clusters may be distributions of dSoH values calculated by corresponding to each of one or more factor combination features included in each cluster. A more specific example embodiment with respect to distributions of a dSoH of each cluster, which are identified as a result of clustering related to a specific factor combination, will be described in detail hereinafter with reference to FIG. 5.

Meanwhile, according to an example embodiment, the first condition, which is a foundation for distinguishing whether to correspond to a factor combination related to battery degradation, may include at least one of a condition as to whether data distributions of each of a plurality of clusters overlap each other and a condition with respect to a difference between data average values of each of a plurality of clusters. Specifically, the condition as to whether the data distributions of each of the plurality of clusters overlap each other may be a condition as to whether clusters, having data distributions of each cluster not overlapping each other, are identified by a number equal to or greater than a predetermined number among a plurality of clusters, and the condition with respect to the difference between the data average values of each of the plurality of clusters may be a condition as to whether a value equal to or greater than a predetermined value is identified among absolute values of a difference between data average values of each of a plurality of clusters, and the first condition may include at least one of the conditions. However, because a form of data distribution of each of a plurality of clusters may significantly vary depending on cases, the first condition is not limited to the examples above, and may be set as a more adequate condition for distinguishing to correspond to a factor combination related to battery degradation such as a condition as to whether a user input of a specific type is obtained and the like according to example embodiments.

FIG. 5 illustrates data distribution among a plurality of clusters related to the factor combination 1 according to an example embodiment.

Referring to FIG. 5, the data distribution among the plurality of clusters related to the factor combination 1 may be in a form of a graph 500 having an x axis as a cluster index, and a y axis as a dSoH. The cluster index may refer to an index which is arbitrarily labelled to divide a plurality of clusters from each other, which are generated by performing clustering with respect to a plurality of factor combination features related to the factor combination 1. Accordingly, the plurality of factor combination features related to the factor combination 1 are an example of having been clustered as 10 clusters in total, and the graph 500 may indicate distribution of a dSoH of each of 11 clusters. More specifically, each distribution may be indicated in a range from a minimum value to a maximum value of dSoH values of each of factor combination features in each cluster, and a dot illustrated in each distribution may indicate an average value of the dSoH values of each of the factor combination features in each cluster. Accordingly, a cluster 0 may have, as an average, a dSoH value of approximately 0.35, and may be a cluster consisting of factor combination features having dSoH values from approximately 0.3 to approximately 0.42.

Meanwhile, in an example in which the first condition is a condition as to whether two or more clusters of which data distributions of each cluster do not overlap each other are identified among a plurality of clusters, because the graph 500 includes the cluster 0 and a cluster 9 of which distributions of a dSoH do not overlap each other, the electronic apparatus 100 may identify that the factor combination 1 corresponds to a factor combination related to battery degradation.

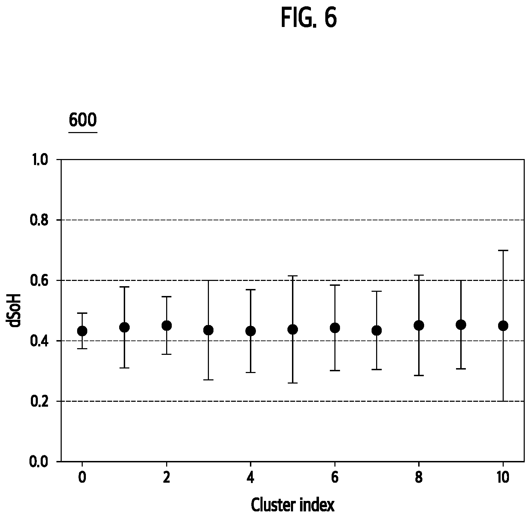

FIG. 6 illustrates data distribution among a plurality of clusters related to the factor combination 2 according to an example embodiment.

Referring to FIG. 6, description related to FIG. 5 may be identically applied, except for being a graph 600 which is the data distribution among the plurality of clusters related to the factor combination 2. Further, according to an identical example related to the first condition in FIG. 5, because the 11 clusters included in the graph 600 do not at all include clusters of which distributions of a dSoH do not overlap each other, the electronic apparatus 100 may identify that the factor combination 2 does not correspond to a factor combination related to battery degradation.

FIG. 7 illustrates a process of identifying information related to an effect on battery degradation caused by each of one or more factor combinations based on an artificial intelligence-based model according to an example embodiment.

According to an example embodiment, the electronic apparatus 100 may extract, with respect to each of the one or more factor combinations, representative factor combination features corresponding to a first type or a second type (operation S701). Here, the first type may be a factor combination feature corresponding to a smallest dSoH value among a plurality of factor combination features corresponding to each factor combination, and may be a factor combination feature causing the least change in a state of health of a battery, whereas the second type may be a factor combination feature corresponding to a greatest dSoH value, and may be a factor combination feature causing the greatest change in the state of health of the battery. Accordingly, for the sake of convenience, a representative factor combination feature corresponding to the first type is referred to as "best feature", whereas a representative factor combination feature corresponding to the second type is referred to as "worst feature". In other words, the electronic apparatus 100 may extract one of the best feature and the worst feature as a representative factor combination feature with respect to each of the extracted factor combinations.

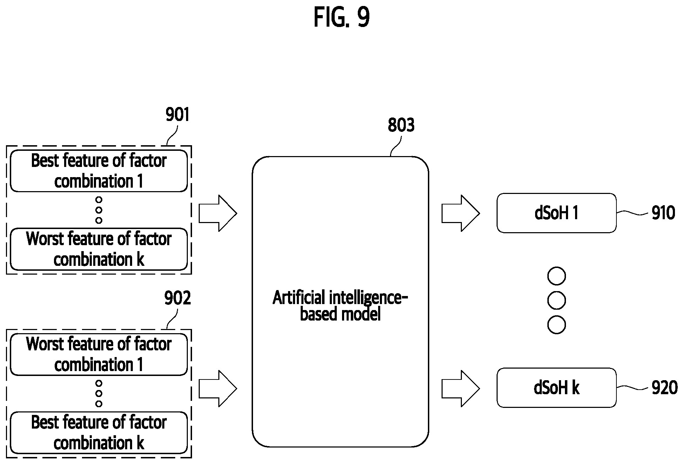

The electronic apparatus 100 may generate a plurality of input data sets including a predetermined SoH value and the extracted representative factor combination features in the first type or the second type as described above, with only one of the representative factor combination features included in each of the plurality of input data sets being generated to correspond to the second type (operation S702). Specifically, in order to identify a dSoH according to an input data set, the electronic apparatus 100 may generate an input data set with the best feature or the worst feature corresponding to each extracted factor combination and an SoH value predetermined at an arbitrary value. Here, the predetermined SoH value may be a reference SoH value set to decide a dSoH due to factor combination features constituting the input data set. Meanwhile, each input data set may be generated in order for only one representative factor combination feature among the representative factor combination features constituting each input data set to correspond to the worst feature, and in order for all the remaining representative factor combination features to correspond to the best feature. In other words, only a representative factor combination feature corresponding to one factor combination included in each of the plurality of input data sets which are generated may be configured to correspond to the worst feature. A more specific example embodiment of each input data set will be described in detail hereinafter with respect to FIG. 9.

The electronic apparatus 100 may input the plurality of input data sets, which are generated as such, into an artificial intelligence-based model (operation S703), and may identify a dSoH corresponding to each of the plurality of input data sets outputted from the artificial intelligence-based model as information related to an effect on battery degradation caused by each of one or more factor combinations (operation S704). For instance, the electronic apparatus 100 may identify an input data set corresponding to a smallest value of a dSoH corresponding to each of the plurality of input data sets, and identify a factor combination corresponding to the worst feature among the representative factor combination features included in the corresponding input data set as the optimal factor combination to provide information related thereto.

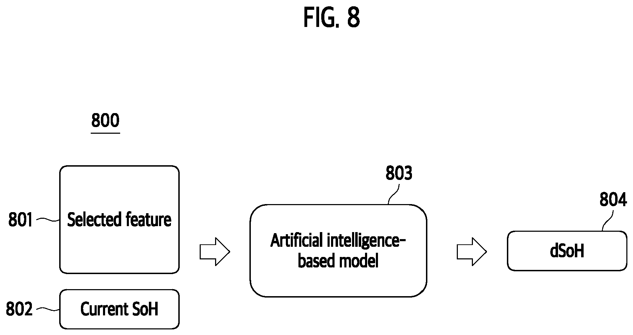

FIG. 8 illustrates a process of training an artificial intelligence-based model according to an example embodiment.

According to an example embodiment, the artificial intelligence-based model utilized by the electronic apparatus 100 to identify the information related to the effect on battery degradation caused by each of the one or more factor combinations extracted as a factor combination corresponding to a factor combination related to battery degradation may be a model constructed by modeling a correlation between a learning input data set and a learning output data set with each of a plurality of factor combination features corresponding to each of the one or more factor combinations and an SoH value of a vehicle corresponding to each of the plurality of factor combination features being the learning input data set, and a dSoH value of the vehicle corresponding to each of the plurality of factor combination features being the learning output data set.

In the present disclosure, deep learning is a process of training a neural network model by using an experience of processing a data set, and software may self-improve data processing capability through the deep learning. The artificial intelligence-based model may be a model generated by modelling a correlation between data sets. Here, the correlation may be expressed by a plurality of parameters. The artificial intelligence-based model may deduce a correlation between data sets by extracting and analyzing features from a provided data set, and repeating such a process to optimize a parameter of the artificial intelligence-based model may be referred to as deep learning. Specifically, the artificial intelligence-based model may learn a correlation between an input and an output with respect to a data set which is provided as an input and output pair according to a deep-learning algorithm. Alternatively, the artificial intelligence-based model may deduce a regularity among data even in a case in which only input data are provided in order to learn a relation thereof. Here, the deep-learning algorithm may be one of a deep neural network, a recurrent neural network, a convolutional neural network, a machine-learning model for classification-regression analysis, and a reinforcement learning model.

The electronic apparatus 100 may model a correlation between a training input data set and a training output data set which are described above according to the deep-learning algorithm as such, thereby constructing an artificial intelligence model. In other words, the electronic apparatus 100 may model a correlation between a learning input data set including a current SoH value of a vehicle corresponding to a factor combination feature and each factor combination feature and each learning output data set (label) of a dSoH of the vehicle corresponding to each learning input data set, thereby constructing the artificial intelligence-based model. Accordingly, the artificial intelligence-based model may, from an input data set including an arbitrary SoH value and an inputted factor combination feature or a plurality of factor combination features, estimate and output a dSoH value corresponding thereto. The electronic apparatus 100 may input a data set constituted with factor combination features corresponding to each of various factor combinations to the artificial intelligence-based model to obtain a dSoH value outputted from the artificial intelligence-based model, thereby identifying quantitative information related to an effect on degradation of a vehicle battery in a more quick and efficient manner.

Referring to FIG. 8, in a process 800 of training the artificial intelligence-based model, the electronic apparatus 100 may set a selected feature 801 and a current SoH value of a vehicle corresponding thereto as the training input data set, and set a dSoH value of the vehicle according to the selected feature 801 as the training output data set. Here, the selected feature signifies a factor combination extracted after having been identified as corresponding to a factor combination related to battery degradation in the present disclosure. The electronic apparatus 100 may train an artificial intelligence-based model 803 based on the training input data set and the training output data set which are set as such.

FIG. 9 illustrates an input data set and an output data set of an artificial intelligence-based model according to an example embodiment.

Referring to FIG. 9, the electronic apparatus 100 may input a k number of input data sets (e.g., an input data set 901, an input data set 902 and the like) in total into the trained artificial intelligence-based model. An input into the artificial intelligence-based model 803 of the k number of input data sets may be performed simultaneously or in parallel, and may be performed sequentially depending on example embodiments. Further, each input data set may include an arbitrary SoH value (omitted in FIG. 9) and a representative factor combination feature of each of the k number of factor combinations. Specifically, the representative factor combination feature of each of the k number of factor combinations may be extracted as the best feature or the worst feature. For instance, the input data set 901 may be an input data set configured by extracting the best feature with respect to each of the factor combination 1 to a factor combination k-1, and the worst feature with respect to a factor combination k. For instance, the input data set 902 may be an input data set configured by extracting the best feature with respect to each of the factor combination 2 to the factor combination k, and the worst feature with respect to the factor combination 1. As such, each input data set may be configured in order for only one of the k number of representative factor combination features to become the worst feature.

The trained artificial intelligence-based model 803 may output a dSoH value corresponding to each of the k number of input data sets which are inputted. Specifically, a dSoH corresponding to the input data set 901 in which only a representative factor combination feature corresponding to the factor combination k is the worst feature may be a dSoH 1 910, and a dSoH corresponding to the input data set 902 in which only a representative factor combination feature corresponding to the factor combination 1 is the worst feature may be a dSoH k 920. As such, the trained artificial intelligence-based model 803 may output a k number of dSoH values.

The electronic apparatus 100 may identify the k number of dSoH values outputted as such as information related to an effect on battery degradation caused by each of the k number of factor combinations. In other words, each of the k number of dSoH values may quantitatively indicate an effect on an SoH of a vehicle battery caused by a factor combination corresponding to the worst feature among representative factor combination features of a corresponding input data set. Accordingly, the electronic apparatus 100 may compare sizes of the k number of dSoH values to each other to identify one worst feature of an input data set corresponding to a dSoH with a smallest value, and identify the factor combination corresponding to the worst feature as an optimal factor combination having a least effect on an SoH of a battery. Meanwhile, because the worst feature of an input data set corresponding to a greatest dSoH value has a greatest effect on an SoH of a battery, the electronic apparatus 100 may identify the same as a factor combination having a greatest adverse effect on battery degradation, and may identify information related to a relative order of a battery degradation effect between factor combinations corresponding to the worst feature of each input data set by aligning the input data sets in an order of a dSoH value.

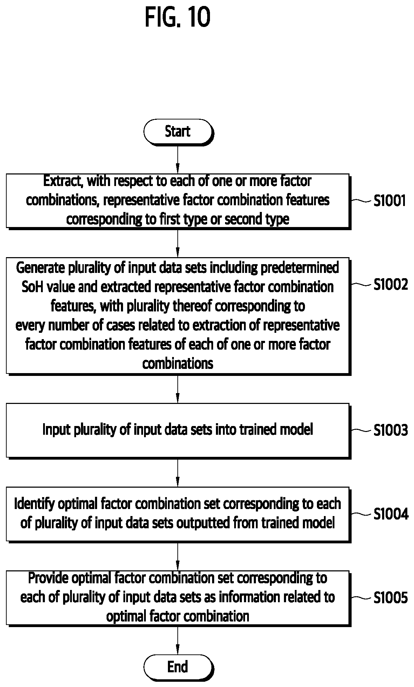

FIG. 10 illustrates a process of identifying an optimal factor combination set based on an artificial intelligence-based model according to an example embodiment.

According to an example embodiment, the electronic apparatus 100 may extract, with respect to each of the one or more factor combinations, representative factor combination features corresponding to a first type (best feature) or a second type (worst feature) (operation S1001), and generate a plurality of input data sets including a predetermined SoH value and the extracted representative factor combination features, with the plurality thereof corresponding to every number of cases related to extraction of the representative factor combination features of each of the one or more factor combinations (operation S1002). In other words, unlike the above-described example embodiments, each of a plurality of input data sets may be configured to include one of the best feature or the worst feature corresponding to each factor combination without a condition with respect to the number of the best features or the worst features. Accordingly, in a case in which one or more factor combinations extracted as a factor related to battery degradation is by the n number, a plurality of input data sets may be generated by the 2ⁿ number.

The electronic apparatus 100 may input the plurality of input data sets generated as such into the trained model (operation S1003), identify the optimal factor combination set corresponding to each of the plurality of input data sets outputted from the trained model (operation S1004), and provide the optimal factor combination set corresponding to each of the plurality of input data sets as the information related to the optimal factor combination (operation S1005).

Here, the trained model may signify a model further trained in order for the artificial intelligence-based model which is constructed and trained as described above to output the optimal factor combination set in which at least one factor combination is changed to correspond to an input data set based on a variation of a SoH corresponding to the input data set. In other words, the trained model may be further trained to, not only output a dSoH corresponding to each input data set, but also output the optimal factor combination set in which a factor combination feature of an input data set is changed in order for a dSoH value corresponding to each input data set to be improved (to be relatively smaller). For this, in an example, a model may be trained to output a configuration of factor combination features corresponding to the smallest dSoH value as the optimal factor combination set. Meanwhile, in another example, the model may output a factor combination set in which any one factor combination feature is changed from a configuration of factor combination features in an inputted current state. Here, any one factor combination feature which is changed may be a factor combination feature which is selected in order for a corresponding dSoH value to be minimized at the maximum degree by the change of the feature thereof. In other words, the trained model may provide a factor combination set, which is provided to reduce a dSoH value to the maximum extent by minimal change in the configuration of the factor combination features, as an optimal battery degradation prevention solution.

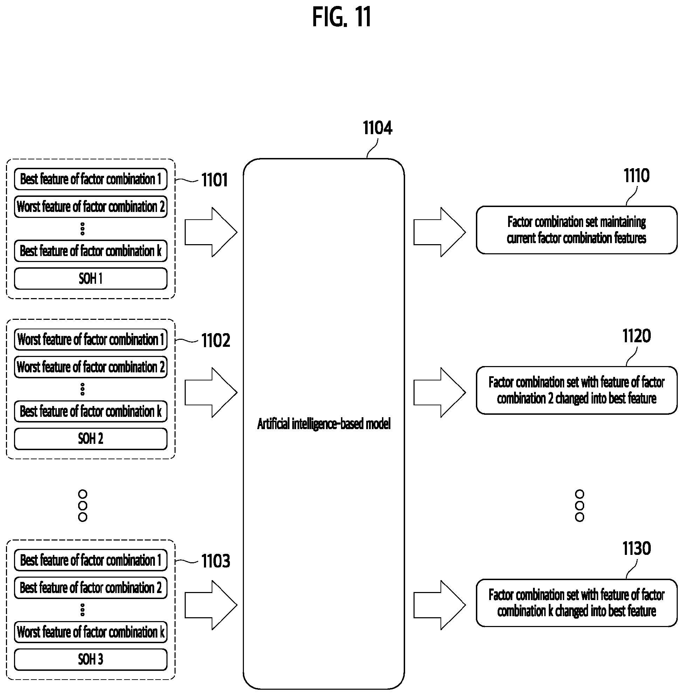

FIG. 11 illustrates an input data set and an output data set of a trained artificial intelligence-based model according to an example embodiment.

Referring to FIG. 11, the electronic apparatus may input a 2^{k} number of input data sets (e.g., an input data set 1101, an input data set 1102, an input data set 1103 and the like) in total into an artificial intelligence model 1104 which is further trained to output the optimal factor combination set. An input of the input data set may be performed simultaneously or in parallel, and may be performed sequentially depending on example embodiments as in FIG. 9. Each input data set may include a best feature or a worst feature corresponding to each of the k number of factor combinations and an SoH value predetermined for deciding a dSoH, and the artificial intelligence model 1104 trained corresponding thereto may output a factor combination set corresponding to each input data set. For instance, the trained artificial intelligence model 1104 may output, in response to the input data set 1101, a factor combination set 1110 maintaining current factor combination features. In other words, it may be identified that, as a dSoH value according to the input data set 1101 corresponds to the minimum value, a configuration of a factor combination set included in the inputted data set is the optimal factor combination set as it is, and, accordingly, the electronic apparatus 100 may provide the same as information related to the optimal factor combination. Meanwhile, the trained artificial intelligence model 1104 may output a factor combination set 1120 in which a feature of the factor combination 2 is changed into a best feature corresponding to the input data set 1102, and such an output may be an output according to a dSoH value corresponding to the input data set 1102 being minimized in a case in which a feature of the factor combination 2 of representative factor combination features of each of the k number of factor combinations is changed from a worst feature into a best feature. Therefore, the electronic apparatus 100 may provide the factor combination set, in which the feature of the factor combination 2 is changed into the best feature, as the information related to the optimal factor combination.

The above-described example embodiments may be implemented by artificial intelligence (AI) through a processor and a memory of an electronic apparatus. The processor may be constituted with a singular processor or a plurality of processors, and the singular processor or the plurality of processors may be a general-use processor such as a central processing unit (CPU), an application processor (AP), a digital signal processor (DSP) and the like, a graphics-only processor such as a graphic processor unit (GPU) and a vision processing unit (VPU), or an artificial intelligence-only processor such as a neural network processing unit (NPU). The singular processor or the plurality of processors may control to process input data according to a pre-defined operation rule stored in a memory or an artificial intelligence model. Alternatively, in a case in which the single processor or the plurality of processors are an artificial intelligence-only processor, the artificial intelligence-only processor may be designed as a hardware structure specialized for processing a specific artificial intelligence model.

The pre-defined operation rule or artificial intelligence model is characterized by having been constructed through learning. Here, being constructed through learning signifies that a basic artificial intelligence model learns by using a plurality of learning data by a learning algorithm in order for the pre-defined operation rule or artificial intelligence model to be constructed, which is set to perform a desired characteristic (or, goal). Such a learning may be performed in an electronic apparatus itself, in which artificial intelligence according to the present disclosure is performed, or may be performed through an additional server and/or system. Examples of a learning algorithm include supervised learning, unsupervised learning, semi-supervised learning or reinforcement learning, without being limited to the above-described examples.

An artificial intelligence model may be constituted with a plurality of neural network layers. Each of the plurality of neural network layers has a plurality of weight values, and may perform neural network calculation through calculation among the plurality of weight values and a calculation result of a previous layer. The plurality of weight values included in the plurality of neural network layers may be optimized by a learning result of the artificial intelligence model. For instance, the plurality of weight values may be renewed in order for a loss value or a cost value obtained from the artificial intelligence model during a learning process to be reduced or minimized. The artificial neural network may include a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-networks or the like, without being limited to the above-mentioned examples.

The electronic apparatus according to the above-described example embodiments may include a processor, a memory for storing and executing program data, a permanent storage such as a disk drive, and/or a user interface device such as a communication port, a touch panel, a key and/or a button that communicates with an external device. Methods implemented as software modules or algorithms are computer-readable codes or program instructions executable on the processor, and may be stored on a computer-readable recording medium. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network in order for computer-readable codes to be stored and executed in a dispersed manner. The medium may be read by a computer, stored in the memory, and executed by the processor.

The present example embodiments may be represented by functional block configurations and various processing steps. These functional blocks may be implemented by various numbers of hardware and/or software configurations that execute specific functions. For example, the example embodiments may adopt integrated circuit configurations such as a memory, a processor, a logic circuit, and a look-up table that may execute various functions by control of one or more microprocessors or other control devices. Similar to that components may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the example embodiments may adopt the related art for electronic environment setting, signal processing, and/or data processing. The terms "mechanism", "element", "means", and "configuration" may be widely used and are not limited to mechanical and physical configurations. The terms may include the meaning of a series of routines of software in association with a processor or the like.

The above-described example embodiments are merely examples, and other example embodiments may be implemented within the scope of the claims to be described later.

## Claims

1. An electronic apparatus comprising:
a transceiver;
a processor; and
one or more memories storing one or more instructions,
wherein, when the one or more instructions are executed, the processor is configured to:
obtain a plurality of battery charging data with respect to a plurality of vehicles; identify, based on the plurality of battery charging data, a plurality of factors related to charging of a battery;
generate, based on the plurality of factors, a plurality of factor combinations;
generate, with respect to each of the plurality of factor combinations, a plurality of factor combination features indicating a charging pattern related to a factor combination based on one or more corresponding battery charging data;
perform, based on a clustering algorithm, clustering targeted at a plurality of factor combination features indicating a charging pattern related to an identical factor combination;
extract, based on a deviation of data distribution among a plurality of clusters generated to correspond to each of the plurality of factor combinations, one or more factor combinations corresponding to a factor combination related to battery degradation among a plurality of factor combinations;
identify, based on an artificial intelligence-based model, information related to an effect on battery degradation caused by each of the one or more factor combinations; and
provide, based on the information related to the effect on battery degradation, information related to an optimal factor combination for preventing battery degradation.

2. The electronic apparatus of claim 1, wherein the plurality of battery charging data are data collected with respect to each of a plurality of batteries included in the plurality of vehicles during a predetermined period, and comprise at least one of:
information related to a state of charge (SoC) of a battery according to time;
information related to a charging current rate (C-rate) of a battery according to time;
information related to a charging temperature of a battery according to time; and
information related to a charging cycle of a battery according to time.

3. The electronic apparatus of claim 1, wherein the plurality of factors comprise at least one of a charging starting SoC, a charging ending SoC, a C-rate, a charging temperature, a charging cycle and a charging time zone.

4. The electronic apparatus of claim 1, wherein, when the one or more instructions are executed, the processor is configured to:
identify one or more battery charging data corresponding to a first factor included in a first factor combination among the plurality of factor combinations,
and one or more battery charging data corresponding to a second factor included in the first factor combination; and
generate, based on the one or more battery charging data corresponding to the first factor and the one or more battery charging data corresponding to the second factor, a plurality of first factor combination features indicating a charging pattern related to the first factor combination.

5. The electronic apparatus of claim 1, wherein, when the one or more instructions are executed, the processor is configured to:
perform, based on a clustering algorithm, clustering of a plurality of first factor combination features corresponding to a first factor combination among the plurality of factor combination features as a plurality of first clusters;
identify whether a deviation between distributions of a variation of a state of health (SoH) of a battery corresponding to each of the plurality of first clusters satisfies a first condition; and
identify, in a case in which the deviation between the distributions of the variation of the SoH corresponding to each of the plurality of first clusters satisfies the first condition, that the first factor combination corresponds to the factor combination related to battery degradation.

6. The electronic apparatus of claim 5, wherein, the distributions of the variation of the SoH corresponding to each of the plurality of first clusters are distributions formed based on a variation of an SoH corresponding to each of one or more first factor combination features included in each of the plurality of first clusters.

7. The electronic apparatus of claim 5, wherein the first condition comprises at least one of a condition as to whether data distributions of each of a plurality of clusters overlap each other and a condition with respect to a difference between data average values of each of a plurality of clusters.

8. The electronic apparatus of claim 1, wherein the artificial intelligence-based model is a model constructed by modeling a correlation between a learning input data set and a learning output data set with each of a plurality of factor combination features corresponding to each of the one or more factor combinations and an SoH value of a vehicle corresponding to each of the plurality of factor combination features being the learning input data set, and a variation of an SoH of a vehicle corresponding to each of the plurality of factor combination features being the learning output data set.

9. The electronic apparatus of claim 8, wherein, when the one or more instructions are executed, the processor is configured to:
extract, with respect to each of the one or more factor combinations, representative factor combination features corresponding to a first type or a second type;
generate a plurality of input data sets comprising a predetermined SoH value and the extracted representative factor combination features, wherein only one of the representative factor combination features included in each of the plurality of input data sets is generated to correspond to the second type;
input the plurality of input data sets into the artificial intelligence-based model; and
identify variations of an SoH corresponding to each of the plurality of input data sets outputted from the artificial intelligence-based model as the information related to the effect on battery degradation caused by each of the one or more factor combinations.

10. The electronic apparatus of claim 9, wherein, when the one or more instructions are executed, the processor is configured to:
identify an input data set corresponding to a smallest value among the variations of the SoH corresponding to each of the plurality of input data sets; and
identify a factor combination corresponding to the second type among representative factor combination features included in the identified input data set as the optimal factor combination.

11. The electronic apparatus of claim 8, wherein the artificial intelligence-based model is a model further trained to output an optimal factor combination set in which at least one factor combination is changed to correspond to an input data set based on variations of an SoH corresponding to an input data set.

12. The electronic apparatus of claim 11, wherein, when the one or more instructions are executed, the processor is configured to:
extract, with respect to each of the one or more factor combinations, representative factor combination features corresponding to a first type or a second type;
generate a plurality of input data sets comprising a predetermined SoH value and the extracted representative factor combination features, wherein the plurality thereof corresponds to every number of cases related to extraction of the representative factor combination features of each of the one or more factor combinations;
input the plurality of input data sets into the trained model;
identify the optimal factor combination set corresponding to each of the plurality of input data sets outputted from the trained model; and
provide the optimal factor combination set corresponding to each of the plurality of input data sets as the information related to the optimal factor combination.

13. A method for analyzing a factor of battery degradation which is executed by an electronic apparatus, the method for analyzing the factor of battery degradation comprising:
obtaining a plurality of battery charging data with respect to a plurality of vehicles;
identifying, based on the plurality of battery charging data, a plurality of factors related to charging of a battery;
generating, based on the plurality of factors, a plurality of factor combinations;
generating, with respect to each of the plurality of factor combinations, a plurality of factor combination features indicating a charging pattern related to a factor combination based on one or more corresponding battery charging data;
performing, based on a clustering algorithm, clustering targeted at a plurality of factor combination features indicating a charging pattern related to an identical factor combination;
extracting, based on a deviation of data distribution among a plurality of clusters generated to correspond to each of the plurality of factor combinations, one or
more factor combinations corresponding to a factor combination related to battery degradation among a plurality of factor combinations;
identifying, based on an artificial intelligence-based model, information related to an effect on battery degradation caused by each of the one or more factor combinations; and
providing, based on the information related to the effect on battery degradation, information related to an optimal factor combination for preventing battery degradation.

14. A non-transitory computer-readable recording medium having a program for executing the method for analyzing the factor of battery degradation of claim 13 on a computer.
